# EUROPEAN PATENT SPECIFICATION

(11) **EP 0 503 926 B1**
(45) Date of publication and mention of the grant of the patent: **25.06.1997**
(21) Application number: 92302089.5
(22) Date of filing: 11.03.1992
(51) Int. Cl.: G06F 11/26

(54) **Bidirectional boundary-scan circuit**
Bidirektionaler Boundary-Scan-Schaltkreis
Circuit bidirectionnel de boundary-scan

(30) Priority: 13.03.1991 US 668531
(43) Date of publication of application: 16.09.1992
(73) Proprietor: NCR International, Inc., Dayton, Ohio 45479 (US)
(72) Inventor: Simpson, David L., West Columbia, SC 29170 (US); Hutton, Edward W., Jr., Columbia, SC 29209 (US)
(74) Representative: Robinson, Robert George

(56) References cited:
- EP-A- 0 358 376
- EP-A- 0 358 376
- US-A- 4 799 004
- US-A- 4 799 004
- 'COMP EURO 89', 8 - 12 May 1989, Hamburg, DE, pages 5.116 - 5.119, IEEE, New
- York, US; C. W. STARKE: 'An efficient self-test strategy for testing VLSI- chips'

## Description

The present invention relates to a bidirectional boundary-scan circuit.

The semiconductor industry has adopted IEEE Std. 1149.1 (1990) as a standard test architecture. The adoption of this standard seeks to provide compatibility of test control and data signals between devices from different manufacturers in much the same way that logic compatibility within a logic family exists. Such a standard test architecture will allow the development of standard tests and standard test development techniques.

The standard architecture has provisions for numerous types of testing. Boundary-scan testing and built-in-self-test (BIST) testing are two of the commonly used provisions.

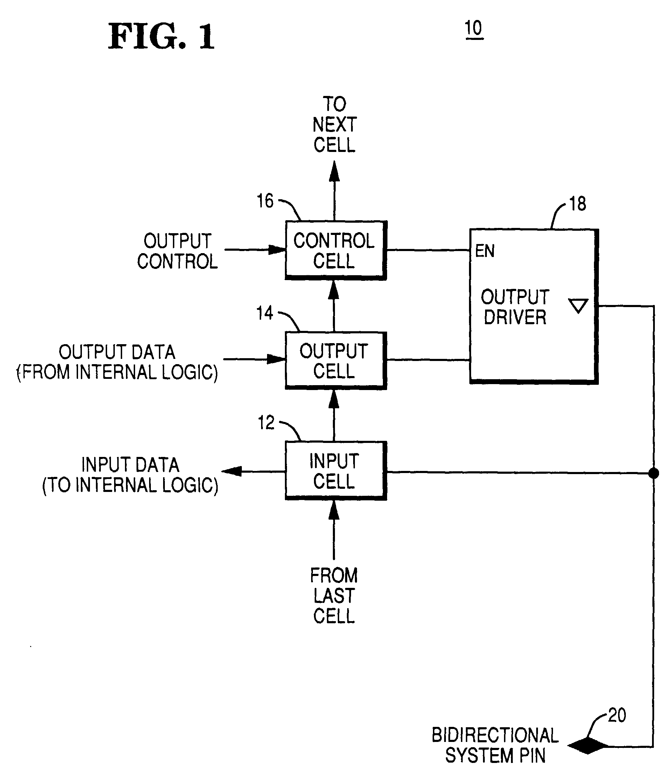

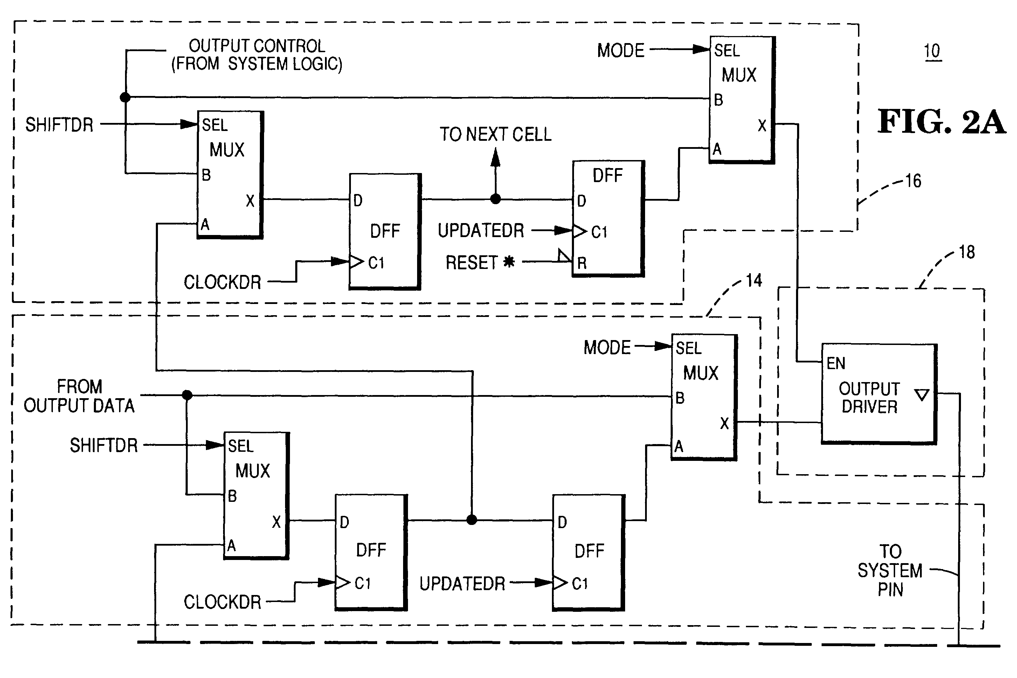

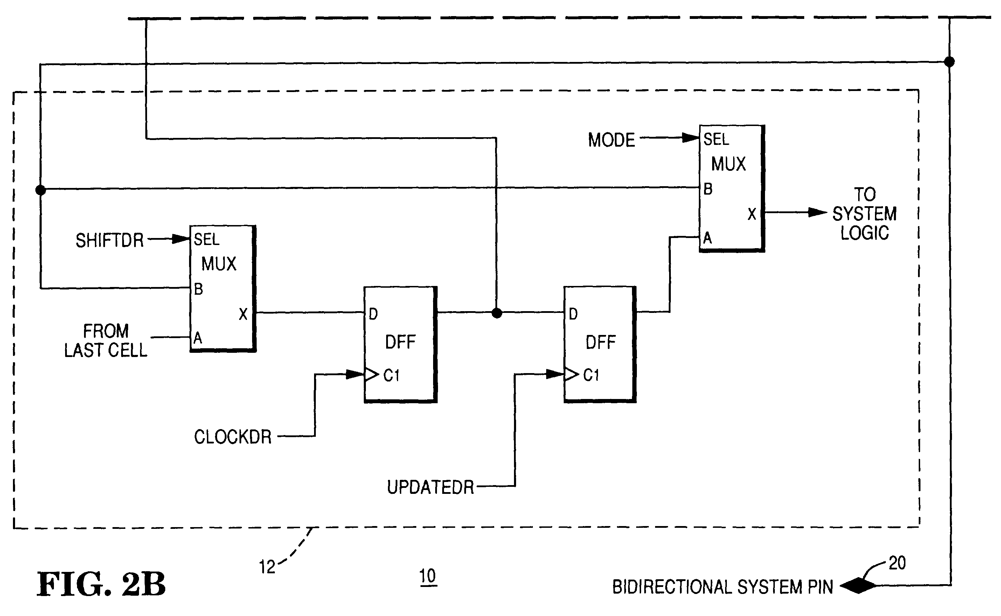

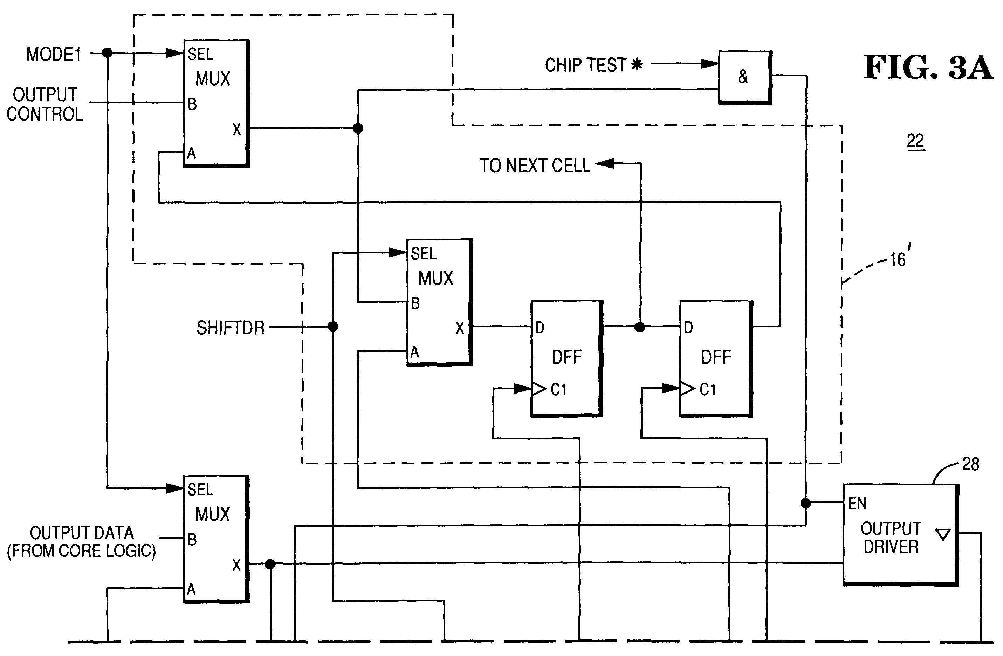

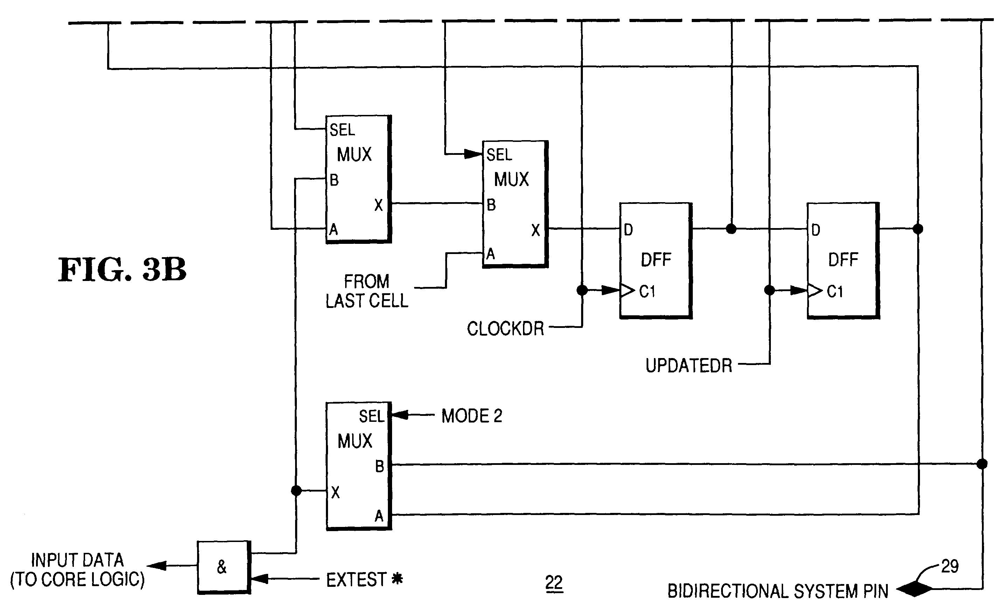

To provide boundary-scan testing, a boundary-scan circuit arrangement is included in an electronic device between the connection pins and the remainder of the device that it is a part of. These connection pins, or simply pins, may connect to inputs, outputs or inputs/outputs of the electronic device, which means the boundary-scan circuits may be input, output or bidirectional in nature. Some implementations of input and of output boundary-scan circuits are shown in the above-mentioned standard. The input circuit and the output circuit each use approximately four sub-circuits to provide the functions necessary for the input or the output boundary-scan circuit. The standard also shows two implementations for bidirectional boundary-scan circuits. The first of the bidirectional circuits is shown in Fig. 1, which is a general description of a bidirectional boundary scan circuit. Figs. 2A and 2B show one realization of Fig. 1, using the input boundary-scan circuit and the output boundary-scan circuit most often used in the standard. Figs. 3A and 3B together show a second implementation of a bi-directional boundary-scan circuit.

The bi-directional boundary-scan circuit shown in Figs. 2A and 2B has twelve sub-circuit functions: six D-type flip-flops (DFF) and six two-to-one multiplexers (2-to-1 MUXs). The bi-directional boundary-scan circuit shown in Figs. 3A and 3B likewise has twelve sub-circuit functions: four DFF, six 2-to-1 MUXs and two AND gates. Considering that bi-directional pins of an electronic device often come in multiples of eight, for example an input/output data bus connection, the amount of area taken up by bi-directional boundary-scan circuits can become substantial. This causes the designer of the electronic device to disadvantageously limit the extent that boundary-scan is provided on the electronic device because of the extra costs involved.

EP 358 376 Texas Instruments discloses a unidirectional test cell for boundary scan testing of integrated circuits based on two multiplexers in association with a flip flop and a latch, but requires a further three multiplexers to provide a bi-directional capability.

It is an object of the present invention to reduce the area required by a bi-directional boundary scan circuit in a semiconductor device.

It is also an object of the present invention to provide such a bi-directional boundary scan circuit that can include a bi-directional BIST capability.

The aforementioned objects are attained by the invention as set forth in the appended claims.

According to the present invention there is provided a bi-directional boundary-scan circuit connected to a bi-directional pin on an electronic device, characterized by common register means for receiving input and output boundary-scan test signals.

The invention advantageously provides for a smaller and more compact bi-directional boundary-scan circuit, than available in the prior art, and one which also reduces the number of active devices required to implement such a scan circuit.

The invention is described further hereinafter, by way of example only, with reference to the accompanying drawings in which:-
Fig 1 is a block diagram of a bidirectional boundary-scan circuit known from IEEE 1149.1.
Fig 2A and 2B form a block diagram of one embodiment of the circuit of Fig 1;
Fig 3A and 3B form a block diagram of another embodiment of a bidirectional boundary-scan circuit known from IEEE 1149.1.
Fig 4 is a block diagram of a bidirectional boundary-scan circuit embodying to the present invention; and
Fig 5 is a block diagram of the bidirectional boundary-scan comprising the circuit shown in Fig. 4 which also allows for the use of BIST testing signals.

Referring to Fig. 1, there is shown a high level block diagram of a bidirectional boundary-scan circuit 10. Fig. 1 corresponds to Fig. 10-21, Example 1, of IEEE 1149.1. The bidirectional boundary-scan circuit 10 is a combination of an input cell 12 and an output cell 14 to provide the bidirectional capability. Further, a control cell 16 and a tri-state output driver 18 control the circuit 10 to operate in normal input mode, normal output mode, boundary-scan input mode or boundary-scan output mode with a bidirectional system pin 20.

Fig 2A and 2B form a more detailed block diagram of the bidirectional boundary-scan circuit 10. Figs 2A and 2B show the bidirectional boundary-scan circuit 10 with specific known cells substituted for the three cells referenced in Fig. 1. The input cell 12 and the output cell 14 are the same as the cell shown in Fig 10-12 of IEEE 1149.1 which is suggested for either input or output use. The control cell 16 shown in Fig 10-21 of IEEE 1149.1 is explicitly recommended for use as the control cell. The control cell 16 and the output driver 18 are standard features. The control cell 16, as shown by dashed lines in Fig 2A consists of two 2-to-1 MUXs and two DFFs. The bidirectional portion of the circuit 10, i.e. the input and output circuits shown in Figs. 2A and 2B consist of four 2-to-1 MUX cells and four memory cells, in this case DFF cells in order to provide boundary-scan capability for one bidirectional pin. Since bidirectional pins often occur in multiples of eight, for example to connect an integrated circuit chip to a bidirectional system bus, a reduction of even one cell result in a substantial savings in semiconductor area required for the overall boundary-scan capability and also in cost.

Figs. 3A and 3B together form a block diagram of a second bidirectional boundary-scan circuit 22 known from Fig 10-22 Example 2 of IEEE 1149.1. The cell complement of this known circuit 22 is slightly different than that of the bidirectional circuit 10 shown in Figs. 2A and 2B. The bidirectional circuit 22 has six 2-to-1 MUX cells, two AND cells and four memory cells, in this case DFFs. Two of the 2-to-1 MUXs and two of the DFFs comprise the output control circuit 16'. So, besides the output driver 28 and the output control circuit 16, the remainder of the bidirectional circuit 22 consists of eight cells to multiplex or switch data to or from the bidirectional pin 29.

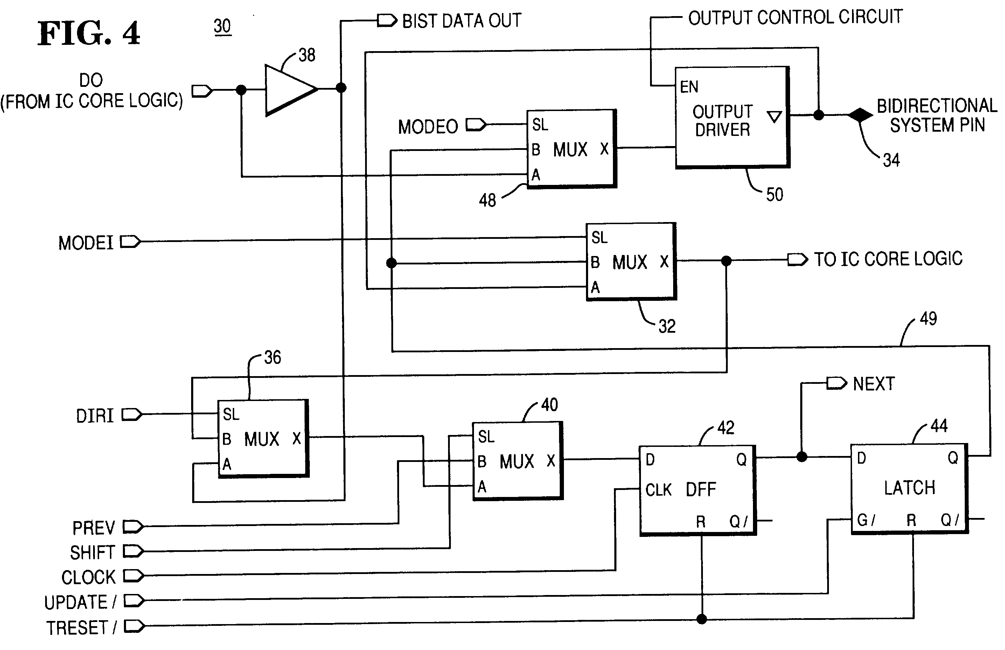

Referring now to Fig. 4, a block diagram of a bidirectional boundary-scan circuit 30 is shown having a 2-to-1 MUX 32 that has one of its two data inputs connected to a bidirectional system pin 34. The second data input of the 2-to-1 MUX 32 is connected to an output of a latch 44, which will be described in greater detail below. The 2-to-1 MUX 32 also has a select input for receiving a control signal MODEI that if asserted, i.e. set to logic high, causes the 2-to-1 MUX 32 to multiplex the first data input to a data output thereof. Conversely, if the MODEI control signal is not asserted, i.e. reset to logic low, the 2-to-1 MUX 32 multiplexes the signal received from the latch 44 via its second data input to its output. The data output of 2-to-1 MUX 32 is connected to an input of core logic within the integrated circuit associated with the bidirectional boundary-scan circuit 30.

The output of 2-to-1 MUX 32 is further connected to one data input of another 2-to-1 MUX 36. A second data input of the 2-to-1 MUX 36 is connected to an output D0 from the core logic of the integrated circuit via a non-inverting buffer 38. The non-inverting buffer 38 is primarily to ensure sufficient drive capabilities and may be omitted if there is sufficient drive available. The 2-to-1 MUX cell 36 has a select input connected to a direction input (DIRI) control signal from test/operate enable control circuits (not shown) within the integrated circuit.

In operation, the 2-to-1 MUX 36 will multiplex either the signal from output of 2-to-1 MUX 32, which typically is the input signal on the bidirectional pin 34, or the signal at the output of non-inverting buffer 38, which typically is the output of the core logic (not shown) to a test input (not shown, but may be a BIST input signal or a boundary-scan input signal) from their respective data inputs of the 2-to-1 MUX 36 to the output thereof.

The output of the 2-to-1 MUX cell 36 is connected to one data input of a further 2-to-1 MUX cell 40. A second data input of the 2-to-1 MUX cell 40 is connected to a previous boundary-scan register cell output to form a larger serial IEEE 1149.1 boundary-scan circuit (not shown). A select input of the 2-to-1 MUX cell 40 is connected to a shift control signal which controls the multiplexing of either logic signals from the output of the previous 2-to-1 MUX cell 36 or from the previous boundary-scan register cell (not shown) to an output of 2-to-1 MUX cell 40.

The output of the 2-to-1 MUX cell 40 is connected to a data (D) input of a DFF 42. A clock input of the DFF 42 is connected to clock signals (not shown) that shift data in from the 2-to-1 MUX cell 40. The clock signal is coordinated with the state of the shift control signal to either shift test data into or out of the core logic circuits, or to shift boundary-scan data along a serial chain of registers in a manner well known from IEEE 1149.1.

The DFF 42 has a non-inverting output that is connected to a next boundary-scan register (not shown) to form part of the serial IEEE 1149.1 boundary-scan circuit mentioned previously. The non-inverting output of DFF 42 is also connected to a latch 44 such as a type LATRP shown in NCR ASIC Data Book 1989 by NCR Corporation, Dayton, Ohio. The IEEE 1149.1 standard suggests the use of some type of one bit register or memory after the boundary-scan register, e.g. DFF 42, to stabilize and control the data and suggests the use of a latch or a DFF as this one bit register or memory device. The circuit 30 shows a latch 44 at this location, but the slightly larger DFF cell could be used instead.

The DFF 42 and the latch 44 each has a test reset input. These two reset inputs are arranged to receive a test reset signal TRESET/ that is essentially the same as the boundary-scan reset signal described in IEEE 1149.1. Similarly, the gating input of the latch 44 is connected to a gating control signal that essentially the same as the update signal described in IEEE 1149.1.

The non-inverted output of the latch 44 is connected via line 49 to the previously mentioned second data input of the 2-to-1 MUX 32. The output of the latch 44, when active, typically carries some type of test signal. Thus, line 49 connects test signals to the second data input of the 2-to-1 MUX 32. If MODEI controls the 2-to-1 MUX 32 to select the second data input, the output of the latch 44 is connected to an input of the core logic of the integrated circuit via line 49 and 2-to-1 MUX 32 as part of some type of test procedure. The gate input and the reset input of the latch 44 provide numerous predetermined ways of manipulating test data into the core logic.

The non-inverted output of the latch 44 is also connected to a data input of another 2-to-1 MUX cell 48. A second data input of the 2-to-1 MUX cell 48 is connected to the output D0 from the core logic of the integrated circuit either directly, or via a non-inverting buffer 38 (this alternate connection is not shown) if a higher drive is necessary. A select input of the 2-to-1 MUX cell 48 is connected to a control signal MODEO which if asserted, which in this case means a logic 1, causes the 2-to-1 MUX 48 to multiplex a data signal from the data input connected to the output of the latch 44 to a data output of the 2-to-1 MUX 48. Conversely, if the MODEO control signal is not asserted, which in this case means a logic 0, the 2-to-1 MUX 48 multiplexes an output signal DO from the input connected thereto to the output of the 2-to-1 MUX 48, which often is the same as the output to the bidirectional system pin 50 as explained below.

The 2-to-one MUX 48 either multiplexes a signal from D0, i.e. a core logic output, to the output of the 2-to-1 MUX 48, which is the data path for normal operations, or multiplexes a signal from the output of latch 44 to the output of 2-to-1 MUX 48, which is usually the data path for various test operations.

The output of the 2-to-1 MUX 48 is connected to an output driver 50 and an output of the output driver 50 is connected to the bidirectional pin 34. The output driver 50 has an enable control input that is connected to an output control circuit (not shown), such as the control cell 16 shown in Fig. 2A, and is controlled by a signal therefrom. This control signal disables the output driver 50 when an output to the bidirectional pin 34 is not desired, for example during an input operation, and enables the output of the output driver 50 to drive the bidirectional pin 34 with the signal it receives from the 2-to-1 MUX 48 when an output is desired. Output drivers, such as the output driver 50, and the control of output drivers are well known in the art.

The bidirectional boundary-scan circuit 30 has one switch 32, three 2-to-1 MUXs 36, 40, 48, one buffer 38, one DFF 42 and one latch 44 for a total of seven cells in addition to the output driver 50 which is present in most bidirectional pin circuits. These seven cells form a more compact bidirectional boundary-scan circuit than the eight cells required by the bidirectional boundary-scan circuits shown in Figs. 2A and 2B or Figs. 3A and 3B. Cells are saved by switching both input or output test signals through the same register cells DFF 42 and latch 44 for input boundary-scan and output boundary-scan procedures.

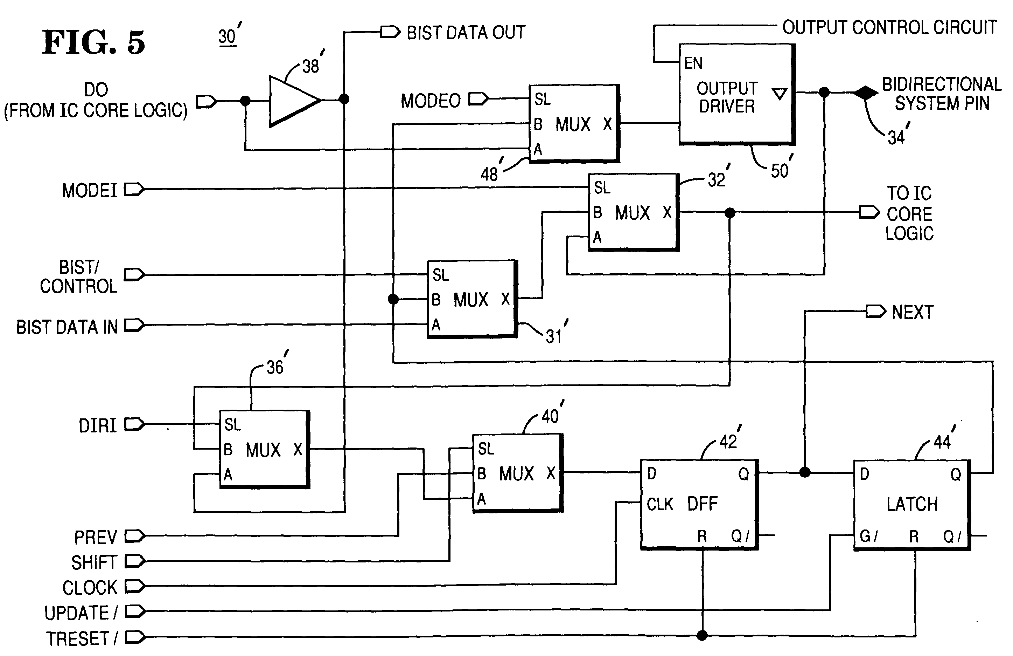

Referring now to Fig. 5, another embodiment of a bidirectional boundary-scan circuit 30' according to the present invention is illustrated in block diagram form. The bidirectional boundary-scan circuit 30' is substantially the same as the bidirectional boundary-scan circuit 30 shown in Fig. 4 with a few differences.

The bidirectional boundary-scan circuit 30' has a 2-to-1 MUX 31' that has one data input connected to a BIST signal from core logic (not shown) within the integrated circuit that the circuit 30' is a part of. A second data input of the 2-to-1 MUX 31' is connected to an output of a latch 44' which is essentially the same as the latch 44 shown in Fig. 4. An output of the 2-to-1 MUX 31' is connected to one data input of a 2-to-1 MUX 32'. The other input of the 2-to-1 MUX 32' is connected to a bidirectional system pin 34' essentially as the first data input of 2-to-1 MUX 32 is connected to its bidirectional system pin 34 as shown in Fig. 4.

The 2-to-1 MUX 31' has a select input that connects to an active low control signal BIST/ from control circuits within the integrated circuit (not shown). If BIST/ is active low, the 2-to-1 MUX 31' multiplexes the BIST data from core logic through the input attached thereto to the output of 2-to-1 MUX 31'. Conversely, if BIST/ is not active low, the 2-to-1 MUX 31' multiplexes the signal from the output of latch 44', which is typically a boundary-scan test signal of some type. Thus, the addition of the 2-to-1 MUX 31' to the circuit otherwise shown in Fig. 4 adds the ability to use the bidirectional boundary-scan circuit also for providing BIST test signals to and from the core logic within the integrated circuit. All of this functionality in the relatively small circuit 30' that has five 2-to-1 MUX cells, a DFF cell, a latch cell, and a buffer cell in addition to the output driver cell.

Thus, it will now be understood that disclosed a bidirectional boundary-scan circuit is disclosed which provides full bidirectional boundary-scan functionality in seven simple logic cells in addition to an output control circuit and an output driver. Further, there has been disclosed a bidirectional boundary-scan circuit which provides full bidirectional boundary-scan functionality and BIST functionality in eight simple logic cells in addition to an output control circuit and an output driver. This is a substantial improvement over the boundary-scan circuits suggested by IEEE 1149.1. While the invention has been particularly illustrated and described with reference to a preferred embodiment thereof, it will be understood by those skilled in the art that various changes in form, details, and applications may be made therein.

## Claims

1. A bi-directional boundary-scan circuit (30,30') connected to a bi-directional pin (34,34') on an electronic device, including storage means (42,44;42',44') for receiving input and output boundary-scan test signals, said storage means comprises a flip-flop (42,42'); and further including first, second, third and fourth multiplexers (32,32'; 36,36'; 40,40', 48,48') characterized by said first multiplexer (32,32') having a first data input connected to said bi-directional pin (34,34'), a second data input, a select input for receiving an input/output control signal and an output connected to an input of a logic circuit within said electronic device, in which said first multiplexer (32,32') switches said first input to said output when enabled to receive an input by said input/output control signal and switches said second input to said output when not enabled by said input/output control signal; said second multiplexer (36,36') having a first data input connected to the output of said first multiplexer (32,32') a second data input connected to an output of a logic circuit of said electronic device, a select input for receiving a direction control signal, and an output; said third multiplexer (40,40') having a first data input connected to said output of said second multiplexer (36,36') a second data input connected to another boundary scan circuit, a select input for receiving a shift control signal, and an output; said flip-flop (42,42') having a data input connected to said output of said third multiplexer (40,40'), a clock input for receiving a boundary-scan clock signal and a non-inverting output; said storage means including a register (44,44') for storing a data bit and having a data input connected to said output of said flip-flop (42,42'), a control input for sampling said input data bit to be stored until the next sampling, and a non-inverting output; whereby said flip-flop (42,42') is controlled by said control signals to store input data during input tests and output data during output tests; and a fourth multiplexer (48,48') having an input connected to said non-inverting output of said register (44,44'), a second input connected to an output of the internal logic of said electronic device, a select input for receiving a second input/output control signal, and an output.

2. A bi-directional boundary-scan circuit (30,30') according to claim 1 further characterized by an output driver (50,50') having an input connected to said output of said fourth multiplexer (48,48'), an output connected to said bi-directional pin (34,34'), and an enable control input for receiving a signal that enables or disables said output driver (50,50') from driving said bi-directional pin (34,34') with a signal output from said fourth multiplexer (48,48') whereby said input/output enable signal logically connects the output of said fourth multiplexer (48,48') to said bi-directional pin (34,34') if enabled and logically disconnects the output of said third multiplexer (40,40') from said bi-directional pin (34,34') if disabled.

3. A bi-directional boundary-scan circuit (30') according to claim 2 characterized by a fifth two-to-one multiplexer (31') having an output connected to the second data input of the first multiplexer (32'), a first data input for receiving a BIST signal of said electronic device, a second data input connected to said non-inverting output of said register (44'); and a select input for receiving a BIST/Boundary-Scan select signal, whereby said output of said register means can be multiplexed to the output of said first multiplexer (32') and by way of said first multiplexer (32') to said internal logic so as to convey a boundary-scan logic signal.

4. A circuit according to any one of claims 1 to 3, characterized in that said non-inverting output of said flip-flop (42,42') is also connected to an input of an upstream boundary-scan circuit.

5. A circuit according to any one of claims 1 to 4, characterized in that said register (44,44') comprises a D-type flip-flop.

6. A circuit according to any one of claims 1 to 5, characterized in that said register (44,44') comprises a latch.

7. A circuit according to any one of the preceding claims, characterized in that said electronic device comprises an integrated circuit.

## Patentansprüche

1. Eine bidirektionale Boundary-Scan-Schaltung (30, 30'), die mit einem bidirektionalen Anschluß (34, 34') an einer elektronischen Einrichtung verbunden ist, einschließlich einer Speichereinrichtung (42, 44; 42', 44') zum Empfangen von Eingangs- und Ausgangs-Boundary-Scan-Prüfsignalen, wobei die Speichereinrichtung ein Flip-Flop (42, 42') aufweist; und ferner einen ersten, einen zweiten, einen dritten und einen vierten Multiplexer (32, 32'; 36, 36'; 40, 40'; 48, 48') umfaßt, gekennzeichnet durch den ersten Multiplexer (32, 32') mit einem ersten Dateneingang, der mit dem bidirektionalen Anschluß (34, 34') verbunden ist, einem zweiten Dateneingang, einem Auswahleingang zum Empfangen eines Eingangs-/Ausgangs-Steuersignals und einem Ausgang, der mit einem Eingang einer Logikschaltung innerhalb der elektronischen Einrichtung verbunden ist, bei der der erste Multiplexer (32, 32') den ersten Eingang zum Ausgang schaltet, wenn er freigegeben ist, so daß ein Eingangssignal durch das Eingangs-/Ausgangs-Steuersignal empfangen wird, und den zweiten Eingang zu dem Ausgang schaltet, wenn er nicht durch das Eingangs-/Ausgangs-Steuersignal freigegeben ist; den zweiten Multiplexer (36, 36') mit einem ersten Dateneingang, der mit dem Ausgang des ersten Multiplexers (32, 32') verbunden ist, einem zweiten Dateneingang, der mit einem Ausgang einer Logikschaltung der elektronischen Einrichtung verbunden ist, einem Auswahleingang zum Empfangen eines Richtungssteuersignals und einem Ausgang; den dritten Multiplexer (40, 40') mit einem ersten Dateneingang, der mit dem Ausgang des zweiten Multiplexers (36, 36') verbunden ist, einem zweiten Dateneingang, der mit einer anderen Boundary-Scan-Schaltung verbunden ist, einem Auswahleingang zum Empfangen eines Schiebesteuersignals und einem Ausgang; das Flip-Flop (42, 42') mit einem Dateneingang, der mit dem Ausgang des dritten Multiplexers (40, 40') verbunden ist, einem Takteingang zum Empfangen eines Boundary-Scan-Taktsignals und einem nicht-invertierenden Ausgang; die Speichereinrichtung, die ein Register (44, 44') zum Speichern eines Datenbit umfaßt und einen Dateneingang, der mit dem Ausgang des Flip-Flops (42, 42') verbunden ist, einen Steuereingang zum Abtasten der Eingangsdatenbit, die bis zum nächsten Abtasten zu speichern sind, und einen nicht-invertierenden Ausgang aufweist; wobei der Flip-Flop (42, 42') durch die Steuersignale gesteuert wird, Eingangsdaten während Eingangsprüfungen und Ausgangsdaten während Ausgangsprüfungen zu speichern; und einen vierten Multiplexer (48, 48') mit einem Eingang, der mit dem nicht-invertierenden Ausgang des Registers (44, 44') verbunden ist, einem zweiten Eingang, der mit einem Ausgang der internen Logik der elektronischen Einrichtung verbunden ist, einem Auswahleingang zum Empfangen eines zweiten Eingangs/Ausgangs-Steuersignals und einem Ausgang.

2. Eine bidirektionale Boundary-Scan-Schaltung (30, 30') nach Anspruch 1, ferner gekennzeichnet durch einen Ausgangstreiber (50, 50') mit einem Eingang, der mit dem Ausgang des vierten Multiplexers (48, 48') verbunden ist, einem Ausgang, der mit dem bidirektionalen Anschluß (34, 34') verbunden ist, und einem Freigabesteuereingang zum Empfangen eines Signals, das den Ausgangstreiber (50, 50') zum Steuern des bidirektionalen Anschlusses (34, 34') mit einem Signal freigibt oder sperrt, das von dem vierten Multiplexer (48, 48') ausgegeben wird, wodurch das Eingangs-/Ausgangs-Freigabesignal den Ausgang des vierten Multiplexers (48, 48') mit dem bidirektionalen Anschluß (34, 34') logisch verbindet, falls er freigeschaltet ist, und den Ausgang des dritten Multiplexers (40, 40') von dem bidirektionalen Anschluß (34, 34') trennt, falls er gesperrt ist.

3. Eine bidirektionale Boundary-Scan-Schaltung (30') nach Anspruch 2, gekennzeichnet durch einen fünften zwei-zu-eins-Multiplexer (31') mit einem Ausgang, der mit dem zweiten Dateneingang des ersten Multiplexers (32') verbunden ist, einem ersten Dateneingang zum Empfangen eines BIST-Signals der elektronischen Einrichtung, einem zweiten Dateneingang, der mit dem nicht-invertierenden Ausgang des Registers (44') verbunden ist; und einem Auswahleingang zum Empfangen eines BIST-/Boundary-Scan-Auswahlsignals, wodurch der Ausgang der Registereinrichtung zum Ausgang des ersten Multiplexers (32') und über diesen ersten Multiplexer (32') zur internen Logik multiplex ausgegeben werden kann, so daß ein Boundary-Scan-Logiksignal geleitet wird.

4. Eine Schaltung nach einem der Ansprüche 1 bis 3, dadurch gekennzeichnet, daß der nicht-invertierende Ausgang des Flip-Flops (42, 42') auch mit einem Eingang einer vorgeschalteten Boundary-Scan-Schaltung verbunden ist.

5. Eine Schaltung nach einem der Ansprüche 1 bis 4, dadurch gekennzeichnet, daß das Register (44, 44') ein D-Flip-Flop aufweist.

6. Eine Schaltung nach einem der Ansprüche 1 bis 5, dadurch gekennzeichnet, daß das Register (44, 44') einen Zwischenspeicher aufweist.

7. Eine Schaltung nach einem der vorhergehenden Ansprüche, dadurch gekennzeichnet, daß die elektronische Einrichtung eine integrierte Schaltung aufweist.

## Revendications

1. Un circuit de test d'interface bidirectionnel (30, 30') connecté à une broche bidirectionnelle (34, 34') d'un dispositif électronique, y compris un dispositif de stockage (42, 42 ; 42', 44') pour recevoir les signaux de test de d'interface d'entrée et de sortie, lesdits systèmes de stockage comprenant une bascule bistable (42, 42') ; et incluant de plus un premier, un second, un troisième et un quatrième multiplexeurs (32, 32' ; 36, 36' ; 40, 40' ; 48, 48') caractérisés par le fait que ledit premier multiplexeur (32, 32') a une première entrée connectée à ladite broche bidirectionnelle (34, 34'), une seconde entrée et une entrée de sélection pour recevoir un signal de commande d'entrée/sortie et une sortie connectée à l'entrée d'un circuit logique situé dans ledit dispositif électronique, dans lequel ledit premier multiplexeur (32, 32') commute ladite première entrée vers ladite sortie lorsqu'il est activé pour recevoir l'entrée dudit signal de commande d'entrée/sortie, et commute ladite seconde entrée vers ladite sortie lorsqu'il n'est pas activé par ledit signal de commande d'entrée/sortie ; ledit second multiplexeur (36, 36') ayant une première entrée connectée à la sortie dudit premier multiplexeur (32, 32'), une seconde entrée connectée à la sortie d'un circuit logique dudit dispositif électronique, une entrée de sélection pour recevoir le signal de commande de direction, et une sortie ; ledit troisième multiplexeur (40, 40') ayant une première entrée connectée à ladite sortie dudit deuxième multiplexeur (36, 36'), une seconde entrée connectée à un autre circuit de test d'interface, une entrée de sélection recevant un signal de commande de décalage, et une sortie ; ladite bascule bistable (42, 42') ayant une entrée connectée à ladite sortie dudit troisième multiplexeur (40, 40'), une entrée d'horloge pour recevoir un signal d'horloge de test d'interface et une sortie non inverseuse ; ledit stockage incluant un registre (44, 44') pour stocker le bit de donnée et dont la donnée d'entrée est connectée à ladite sortie de ladite bascule bistable (42, 42'), une entrée de commande pour échantillonner ledit bit d'entrée devant être stocké jusqu'au prochain échantillonnage, et une sortie non inverseuse ; dans lequel ladite bascule bistable (42, 42') est commandée par lesdits signaux de commande pour stocker la donnée d'entrée pendant les tests d'entrée et la donnée de sortie pendant les tests de sortie ; et un quatrième multiplexeur (48, 48') ayant une entrée connectée à ladite sortie non inverseuse dudit registre (44, 44'), une seconde entrée connectée à la sortie de la logique interne dudit dispositif électronique, une entrée de sélection pour recevoir un second signal de commande d'entrée/sortie, et une sortie.

2. Un circuit de test d'interface bidirectionnel (30,30') conforme à la revendication 1 et de plus caractérisé par un circuit de sortie (50, 50') ayant une entrée connectée à ladite sortie dudit quatrième multiplexeur (48, 48'), une sortie connectée à ladite broche bidirectionnelle (34, 34'), et une entrée d'activation pour recevoir un signal permettant ou interdisant audit circuit de sortie (50, 50') de commander ladite broche bidirectionnelle (34, 34') avec un signal de sortie dudit quatrième multiplexeur (48, 48') où ledit signal d'activation d'entrée/sortie connecte de façon logique la sortie dudit quatrième multiplexeur (48, 48') à ladite broche bidirectionnelle (34, 34'), s'il est actif et déconnecte logiquement la sortie dudit troisième multiplexeur (40, 40') de ladite broche bidirectionnelle (34, 34'), s'il est inactif.

3. Un circuit de test d'interface bidirectionnel (30') conforme à la revendication 2 et caractérisé par un cinquième multiplexeur deux pour un (31') ayant une sortie connectée à la seconde entrée du premier multiplexeur (32'), une première donnée d'entrée recevant un signal BIST provenant dudit dispositif électronique, une seconde donnée d'entrée connectée à ladite sortie non inverseuse dudit registre (44') ; et une entrée de sélection pour recevoir un signal de sélection BIST/test d'interface, où ladite sortie dudit registre peut être multiplexée vers la sortie dudit premier multiplexeur (32') et, au moyen dudit premier multiplexeur (32'), vers ladite logique interne de façon à transmettre le signal logique de test d'interface.

4. Un circuit conforme à l'une des revendications 1 à 3, caractérisé par le fait que ladite sortie non inverseuse de ladite bascule bistable (42, 42') est aussi connectée à l'entrée d'un circuit de test d'interface situé plus en amont.

5. Un circuit conforme à l'une des revendications 1 à 4, caractérisé par le fait que ledit registre (44, 44') comprend une bascule bistable de type D.

6. Un circuit conforme à l'une des revendications 1 à 5, caractérisé par le fait que ledit registre (44, 44') comprend un latch.

7. Un circuit conforme à l'une des revendications précédentes, caractérisé par le fait que ledit dispositif électronique comprend un circuit intégré.
